# EUROPEAN PATENT SPECIFICATION

(11) **EP 0 360 994 B1**
(45) Date of publication and mention of the grant of the patent: **16.03.1994**
(21) Application number: 89113038.7
(22) Date of filing: 15.07.1989
(51) Int. Cl.: C23C 14/30, C23C 14/32

(54) **Apparatus and method for producing diamond films at low temperatures**
Vorrichtung und Verfahren zur Herstellung von Diamantfilmen bei tiefen Temperaturen
Dispositif et procédé pour la production de films de diamant à basse température

(30) Priority: 20.09.1988 US 247051
(43) Date of publication of application: 04.04.1990
(73) Proprietor: International Business Machines Corporation, Armonk, N.Y. 10504 (US)
(72) Inventor: Smith, David Anthony, Katonah New York 10536 (US); Taranko, Alexander Richard, Jefferson Valley New York 10535 (US)
(74) Representative: Schäfer, Wolfgang, Dipl.-Ing.

(56) References cited:
- EP-A- 0 304 201
- WO-A-88/10321
- JP-A-61 201 693
- US-A- 3 961 103
- US-A- 4 191 735

## Description

The present invention relates to the diamond film deposition art. Specifically, a technique for producing diamond film deposition at low temperatures is described.

Manufacture of electronics components in many instances requires hard surface coatings to protect underlying materials. In the microelectronic art, a substrate including a microelectronic circuit is coated with a vinyl protective packaging layer which keeps the surface of the substrate bearing the electronics components free from contamination. Similarly, magnetic disk media used as a memory medium in computer disk drives also require on the surface thereof a protective film which is both hard and insulating and which does not interfere with the reading and writing of data to the disk. Additionally, future uses of diamond surfaces in the manufacture of computer chip substrates will offer a durability and heat transfer capability which exceeds current substrate design. These materials, because of their ability to shed heat, will permit higher density circuits to be fabricated.

The present techniques for forming diamond films often require the use of high temperatures and/or the presence of numerous contaminants. In order to produce a diamond film of sufficient purity, a tedious measurement and system monitoring are inefficient for high volume, low cost applications.

References in the prior art which describe these various technique for growing synthetic diamond films include US-A-4 191 735, US-A-3 961 103 and US-A-4 486 286.

These techniques employ the use of a plasma for generating ion particles. In US-A-3 961 103, the extracted ions are used to bombard a cathode to sputter or vaporize atoms of a desired material into a discharge space where they are ionized. The plasma therefore contains large concentrations of ions of a desired species, as well as a concentration of contaminants of an undesired species. The substrate which is sputtered is directly exposed to excessive heat and contaminants.

The earlier application WO-A-88/10321 discloses a mass-selected ion beam deposition system comprising an ion source, acceleration system for ion beam transport, mass selection capability for the transmission of only the desired species, deceleration system for achieving and controlling the low ion energies needed for diamondlike film deposition, target substrate assembly, and a deposition chamber maintained at low pressure, preferably with facilities for in situ measurements and controlled gas admission in which the substrate temperature can be varied from cryogenic to upwards of 1000°C.

The present invention as claimed solves the problem of how to provide a technique which will yield a relatively pure diamond film at moderate temperatures, which do not adversely effect typical electronic circuit substrates.

It is an object of this invention to grow diamond films on substrates which are relatively contaminant free.

It is another object of this invention to grow diamond films on a substrate at moderate temperatures which will not adversely effect a substrate.

The problem is solved by an apparatus as claimed in claim 1 and a method as claimed in claim 7. Further advantagous embodiments are claimed in the respective subclaims.

Accordingly a source of carbon ions is generated through the use of an E-gun and carbon block. A standard tungsten filament electron source of an E-gun is used to vaporize the surface of a carbon block. Vaporized carbon atoms collide with the incident electrons, forming a source of carbon ions.

The source of carbon ions is advantageously disposed underneath an apertured plate which serves as a collimator. The apertured plate passes the vaporized carbon ions into a collimated beam. On the opposite side of the collimator plate, two electrostatic field plates are disposed. The electrostatic field plates are advantageously symmetrical with respect to the axis of the aperture in the collimator plate. An electric field is established between the electrostatic field plates. The carbon ions which exit the collimator plate aperture are swept in a direction perpendicular to the collimated beam. A substrate is located in the path of the accelerated carbon ions. A film of the carbon ions, which is substantially diamond, is deposited on the substrates.

The carbon ion beam rises due to the heat of vaporizing the beam. A few charged contaminants are produced from the E-gun and carbon atom collisions. Only the essentially pure carbon ions make it through the shield plate collimator, wherein they are swept by the electrostatic field towards the substrate. The uncharged particles continue travelling in a vertical direction above the substrate and are not directed towards the substrate.

For a better understanding of the present invention, together with further objects, advantages and capabilities thereof, in the following a preferred embodiment of the invention is described with reference to the accompanying drawings, in which:
- Fig. 1: is a front view of apparatus for growing diamond films; and
- Fig. 2: is a side view of the diamond film producing apparatus.

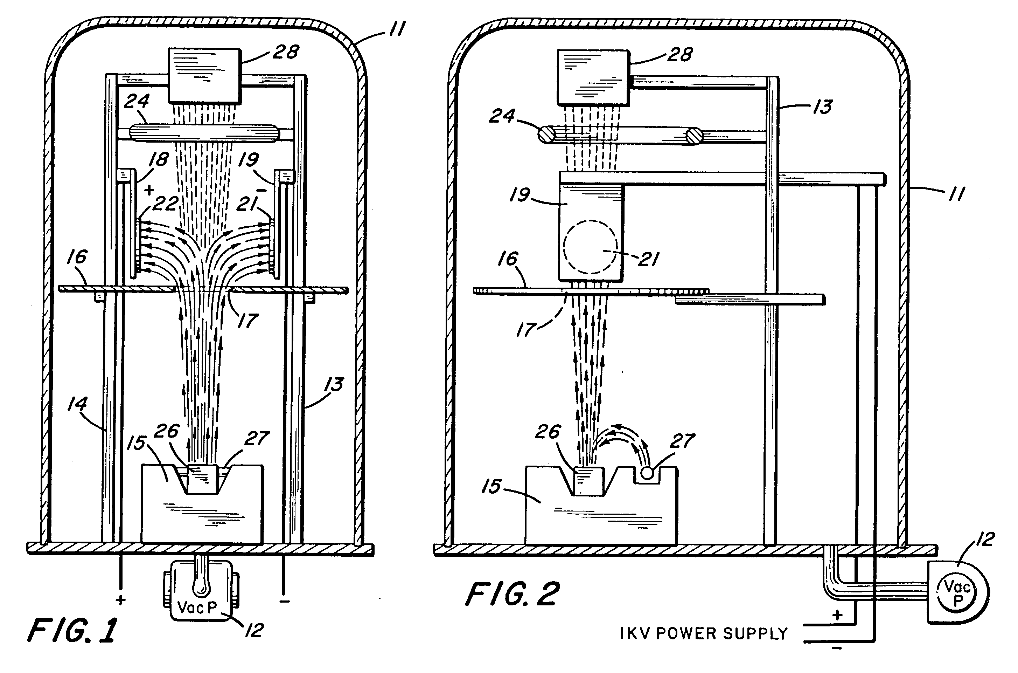

Referring now to Figures 1 and 2, a detailed drawing of an apparatus for producing diamond film at low temperatures is shown. The process is carried out in a vacuum chamber 11 which is connected to a vacuum pump 12. A vacuum of approximately 13,3 mPa (10⁻⁶ Torr) is established inside the chamber 11.

A support frame 13 supports a collimator plate 16 over an E-gun source 15. The collimator plate 16 includes an aperture 17 which will permit a collimated beam of carbon ions to pass through the collimator plate. First and second deflection plates 18 and 19 are shown in Figure 2 comprising a front view of the apparatus. The deflection plates 18 and 19 are connected to a source of voltage potential which is selected to be between 100 and 1,000 Volts. The voltage potential is preferably a DC potential producing an electrostatic field strength of 100 V/cm, but a time varying ramp voltage or alternating voltage potential may be utilized in some instances. The deflection plates 18 and 19 are spaced an equal distance from the axis of the aperture 17. First and second substrates 21 and 22 are placed adjacent the deflection plates 18 and 19, and in the path of an electrostatic field established between plates 18 and 19. An electric heater 24 is positioned inside the vacuum chamber 11 to maintain the temperature at preferably 200°C. It has been found that a moderate temperature of 200°C will not adversely effect most common substrates 21 and 22, yet will promote diamond growth.

A titanium sublimation pump in conjunction with a liquid nitrogen cooled cylindrical surface 28 may be used above the source 15 and deflection field plates 18 and 19, to trap carbon neutrals and obtain a better vacuum.

The E-gun 15 may be a conventional E-gun source such as the Temescal 10KV electron gun, known to those skilled in the vacuum deposition processes having a power 1-6KW. The E-gun 15 is shown as the lowermost component, including a carbon block 26, disposed in the path of an electron source 27 which may be the tungsten filament source associated with the E-gun 15. The carbon block 26 will vaporize along the surface due to the incident electrons. The vaporized particles will rise and collisions with the incident electron source beam results. The collisions and X-rays produced from E-gun operation are such as to produce ions of carbon, of both + and - polarity. Due to the vaporization of the carbon surface, the resulting carbon ions are in a vapor which rises towards the collimator plate 16. The collimator plate 16 includes an aperture to permit passage of the carbon ions. It may also be possible to produce carbon or hydrocarbon ions by interaction of alkanes such as methane and n-butane and the electrons from the E-gun 15.

The collimated carbon ions are relatively pure, including few contaminants, as compared with a conventional plasma used in other prior art diamond film growing systems. The carbon ions exiting the aperture 17 are swept by the electrostatic field between electrode plates 18 and 19 towards one or the other substrates 21 and 22, depending on the polarity of the exiting ions. The bending of the collimated beam at an angle shown to be substantially perpendicular to the axis of the aperture 17 helps separate the charged ions from any unwanted neutral species. Thus, the substrates are kept out of a line of sight path with the source 15. Additionally, the field strength of the electrostatic field will impart sufficient energy to the accelerated ions to promote diamond growth. Over the course of time, a film of diamond material will be deposited on each of the substrates 21 and 22. The foregoing system, depending on the size of the electron source 15, has the capability of depositing from a few hundred nanometer x 0,1 (Angstroms) up to 1 micron thick diamond film layers on substrates 21 and 22. Deposition rates of 3 nm/minute have been obtained. It may also be possible to utilize a magnetic field to bend the ion stream at an angle to the collimated beam.

In tests using apparatus in accordance with the foregoing, diamond film thickness of several hundred to one thousand Angstroms have been deposited on NACL sub-strates. The resulting substrate and diamond film have been viewed under optical microscopes, as well as in spectrometers, to confirm the purity of the diamond film and its uniformity.

Films varying in structure and properties from amorphous diamond-like as in the prior art, to those of a polycrystalline nature, as confirmed by TEM diffraction pattern analysis, can be made by our method. In either case, amorphous or polycrystalline, the films are largely diamond. Diamond films are known to have the following desirable physical properties:
1. very high resistivity
2. insolubility in HF
3. extreme hardness
4. transparency in the visible range
5. good heat conductor
6. high dielectric constant
7. high index of refraction.

The foregoing technique is relatively inexpensive as far as vacuum deposition processes are concerned, and most of the components are standard.

Variations in film properties can be controlled by the degree of shielding used to insure that a minimum number of neutral carbon atoms arrive at the substrate, as well as controlling the electrostatic field strength which in turn determines how much energy the incident ions have during deposition. Carbon neutrals tend to grow as graphite and inhibit the diamond structure growth process. Carbon atoms have a low sticking coefficient and ricochet off vacuum system walls and fixtures and can arrive at places first thought to be in a shielded location of the system. However, with suitable shielding, these multiple trajectories of the carbon atoms can be blocked, insuring that the substrate will receive many more carbon ions than neutrals and a diamond film will result. The quality of this film depends on the percent carbon neutral impurity. The higher the impurity the more the film tends to become amorphous. Less impurity results in polycrystalline high quality films. Above a certain critical amount of impurity, the film is no longer predominantly diamond and begins to conduct or exhibit lower resistivity and loses its transparency. Films of this type may have uses as resistors in microelectronic applications. Other prior art techniques having the substrate in a line of sight path with the source are susceptible to this graphitization impurity problem and try to cope with it with various techniques such as simultaneous or subsequent irradiation with argon, hydrogen, oxygen or carbon dioxide to remove the graphite. These processes, in contrast to the present invention, generate heat and are injurious to any microelectronic circuit chip substrate. Substrate temperatures of from room temperature to 200°C are adequate for producing diamond films with this invention.

With the foregoing process, the temperature is maintained at moderate levels, where 200°C is preferable, but in which much lower temperatures will still promote diamond film growth on a respective substrate. The use of the E-gun and carbon block reduces the contaminant level normally found in conventional plasma generating systems, and the contaminant level is further held to a minimum through use of the apertured collimator.

## Claims

1. An apparatus for producing diamond films at a low temperature on a substrate (21, 22) consisting essentially of
a vacuum-tight vacuum chamber (11);
a collimator plate (16) including an aperture (17) to permit a collimated beam of carbon ions to pass through the collimator plate;
a solid carbon source (15) providing vaporized carbon ions in the vacuum chamber on the first side of the collimator plate;
first and second deflection plates (18, 19) located on the second side of the collimator plate and spaced appart from another both having the equal distance from the axis of the aperture in the collimator plate, said deflection plates establish an electrostatic field between the plates;
substrates (21, 22) placed adjacent the deflection plates and in the path of the electrostatic field between the plates;
a sublimation pump (28) also located on the second side of the collimator plate to trap carbon neutrals;
heating means (24) inside the vacuum chamber.

2. The apparatus of claim 1, wherein said solid carbon source (15) consists essentially of
a source of free electrons (27);
a source of vaporized carbon atoms
(26), said carbon atoms colliding with said free electrons to produce vaporized carbon ions.

3. The apparatus of claim 2, wherein said source of vaporized carbon atoms is a carbon block (26).

4. The apparatus of claim 1, 2 or 3 wherein said electrostatic field is substantially perpendicular to the axis of said aperture and accelerates the carbon ions passing through said aperture at an angle to said aperture axis towards said substrate (21, 22) and separates said carbon ions from other charged particles exiting said aperture.

5. The apparatus of claim 4 wherein said electrostatic field is produced by first (18) and second (19) deflector plates having a voltage potential between 100 and 1,000 Volts.

6. The apparatus of claim 5 wherein said voltage potential has a strength which varies as a function of time.

7. A method for producing diamond films on a substrate at low temperature consisting essentially of
maintaining a temperature not exceeding approximately 200°C;
producing a stream of vaporized carbon ions;
collimating said stream of vaporized carbon ions;
deflecting carbon ions from said collimated beam of said ions separating said carbon ions from other particles in said collimated beam through an angle of approximately 90°; and,
accelerating said deflected carbon ions to a substrate for deposition of a film thereon having substantially diamond structure.

8. The method of claim 7, wherein said carbon ions are produced by collisions between free electrons and carbon atoms.

9. The method of claim 7 wherein said carbon ions are produced by interaction of alkanes and free electrones.

10. The method of one of the preceding claims 7 to 9, wherein said carbon ions are accelerated in an electrostatic field.

11. The method of claim 10, wherein said electrostatic field has a strength of 100 V/cm.

## Patentansprüche

1. Vorrichtung zur Herstellung von Diamantfilmen auf einem Substrat (21, 22) bei einer niedrigen Temperatur, im wesentlichen bestehend aus:
einer vakuumdichten Vakuumkammer (11);
einer Kollimatorplatte (16) mit einer Öffnung (17), die einen parallel gerichteten Strahl aus Kohlenstoffionen durch die Kollimatorplatte hindurch läßt;
einer festen Kohlenstoffquelle (15), die auf der ersten Seite der Kollimatorplatte in der Vakuumkammer verdampfte Kohlenstoffionen liefert;
einer ersten und zweiten Ablenkelektrode (18, 19), die sich auf der zweiten Seite der Kollimatorplatte befinden und Abstand voneinander haben und beide den gleichen Abstand von der Achse der Öffnung in der Kollimatorplatte haben, wobei diese Ablenkelektroden zwischen den Elektroden ein elektrostatisches Feld aufbauen;
Substraten (21, 22), die sich neben den Ablenkelektroden und im Pfad des elektrostatischen Felds zwischen den Elektroden befinden;
einer Sublimationspumpe (28), die sich zum Einfangen neutraler Kohlenstoffspezies ebenfalls auf der zweiten Seite der Kollimatorplatte befindet;
Heizmitteln (24) in der Vakuumkammer.

2. Vorrichtung gemäß Anspruch 1, wobei die feste Kohlenstoffquelle (15) im wesentlichen aus folgendem besteht:
einer Quelle (27) für freie Elektronen;
einer Quelle (26) für verdampfte Kohlenstoffatome, wobei diese Kohlenstoffatome mit den freien Elektronen zusammenstoßen, um verdampfte Kohlenstoffionen zu erzeugen.

3. Vorrichtung gemäß Anspruch 2, wobei die Quelle für verdampfte Kohlenstoffatome ein Kohlenstoffblock (26) ist.

4. Vorrichtung gemäß Anspruch 1, 2 oder 3, wobei das elektrostatische Feld im wesentlichen senkrecht zur Achse der erwähnten Öffnung steht und die Kohlenstoffionen, die die Öffnung passieren, in einem Winkel zur Achse der Öffnung zum Substrat (21, 22) hin beschleunigt und die Kohlenstoffionen von anderen geladenen Teilchen, die die Öffnung passieren, trennt.

5. Vorrichtung gemäß Anspruch 4, wobei das elektrostatische Feld durch eine erste (18) und zweite (19) Ablenkelektrode mit einem Spannungspotential zwischen 100 und 1.000 Volt erzeugt wird.

6. Vorrichtung gemäß Anspruch 5, wobei sich die Stärke des Spannungspotentials als Funktion der Zeit ändert.

7. Verfahren zur Herstellung von Diamantfilmen auf einem Substrat bei niedriger Temperatur, im wesentlichen beinhaltend
Halten einer Temperatur, die etwa 200°C nicht übersteigt;
Erzeugen eines Stroms aus verdampften Kohlenstoffionen;
Parallelrichten des Stroms aus verdampften Kohlenstoffionen;
Ablenken von Kohlenstoffionen aus diesem parallel gerichteten Ionenstrahl, wobei die Kohlenstoffionen von anderen Teilchen im parallel gerichteten Strahl mit einem Winkel von ungefähr 90° getrennt werden; und
Beschleunigen der abgelenkten Kohlenstoffionen zu einem Substrat, um darauf einen Film abzuscheiden, der im wesentlichen Diamantstruktur besitzt.

8. Verfahren gemäß Anspruch 7, wobei die Kohlenstoffionen durch Zusammenstöße zwischen freien Elektronen und Kohlenstoffatomen erzeugt werden.

9. Verfahren gemäß Anspruch 7, wobei die Kohlenstoffionen durch Wechselwirkung von Alkanen und freien Elektronen erzeugt werden.

10. Verfahren gemäß einem der vorstehenden Ansprüche 7 bis 9, wobei die Kohlenstoffionen in einem elektrostatischen Feld beschleunigt werden.

11. Verfahren gemäß Anspruch 10, wobei das elektrostatische Feld eine Stärke von 100 V/cm besitzt.

## Revendications

1. Appareil pour produire des films de diamant à basse température sur un substrat (21, 22) consistant essentiellement en :
une chambre à vide poussé (11),
une platine de collimation (16) comportant une ouverture (17) pour permettre à un faisceau collimaté d'ions carbone de passer à travers la platine, une source de carbone solide (15) fournissant des ions carbone en phase vapeur dans la chambre à vide du premier côté de la platine de collimation,
une première et une seconde plaques de déviation (18,19) placés du deuxième côté de la platine de collimation et séparées l'une de l'autre à une égale distance de l'axe de l'ouverture de la platine de collimation, lesdites plaques de déviation établissant un champ électrostatique entre les plaques,
des substrats (21, 22) placés de façon adjacente aux plaques de déviation et dans le champ électrostatique entre les plaques,
une pompe à sublimation (28) placée également du deuxième côté de la platine de collimation pour capturer les atomes de carbone neutres,
un moyen de chauffage (24) à l'intérieur de la chambre à vide.

2. Appareil selon la revendication 1, dans lequel ladite source de carbone solide (15) consiste essentiellement en
une source d'électrons libres (27),
une source d'atomes de carbone en phase vapeur (26), lesdits atomes de carbone entrant en collision avec lesdits électrons libres pour produire des ions carbone en phase vapeur.

3. Appareil selon la revendication 2, dans lequel ladite source d'atomes de carbone en phase vapeur est un bloc de carbone (26)

4. Appareil selon la revendication 1,2 ou 3 dans lequel ledit champ électrostatique est substantiellement perpendiculaire à l'axe de ladite ouverture et accélère les ions carbone passant à travers ladite ouverture selon un certain angle par rapport à l'axe de ladite ouverture vers ledit substrat (21, 22) et sépare lesdits ions carbone des autres particules chargées sortant par ladite ouverture.

5. Appareil selon la revendication 4, dans lequel ledit champ électrostatique est produit par une première (18) et une seconde (19) plaques de déviation ayant une différence de potentiel entre 100 et 1000 volts.

6. Appareil selon la revendication 5, dans lequel ladite différence de potentiel a une intensité qui varie en fonction du temps.

7. Méthode de production de films de diamant sur un substrat à basse température consistant essentiellement à
maintenir une température n'excédant pas approximativement 200°C,
produire un faisceau d'ions carbone en phase vapeur,
collimater ledit faisceau d'ions carbone en phase vapeur,
dévier les ions carbone dudit faisceau d'ions en séparant lesdits ions carbone des autres particules dans ledit faisceau collimaté selon un angle approximatif de 90°, et
accélérer lesdits ions carbone déviés vers un substrat pour y déposer un film ayant substantiellement une structure de diamant.

8. Méthode selon la revendication 7, dans laquelle lesdits ions carbone sont produits par des collisions entre des électrons libres et des atomes de carbone.

9. Méthode selon la revendication 7, dans laquelle lesdits ions carbone sont produits par interaction entre des alcanes et des électrons libres.

10. Méthode selon une des revendications précédentes 7 à 9, dans laquelle lesdits ions carbone sont accélérés dans un champ électrostatique.

11. Méthode selon la revendication 10, dans laquelle ledit champ électrostatique a une intensité de 100V/cm.
